Europäisches Patentamt

European Patent Office

Office européen des brevets

(11) Veröffentlichungsnummer: **0 359 018**

**A2**

## (12) EUROPÄISCHE PATENTANMELDUNG

(21) Anmeldenummer: **89115843.8**

(51) Int. Cl.5 **H01J 37/30 , H01J 37/317**

(22) Anmeldetag: **28.08.89**

(30) Priorität: **16.09.88 DE 3831526**

(43) Veröffentlichungstag der Anmeldung:
**21.03.90 Patentblatt 90/12**

(84) Benannte Vertragsstaaten:
**DE FR GB NL**

(71) Anmelder: **Siemens Aktiengesellschaft**
**Wittelsbacherplatz 2**
**D-8000 München 2(DE)**

(72) Erfinder: **Lischke, Burkhard, Prof.-Dr.**
**In der Heuluss 13**
**D-8000 München 82(DE)**

(54) **Lithographiegerät zur Strukturierung eines Objektes.**

(57) In modernen Elektronenstrahlschreibern wird das zu strukturierende Objekt mit mehreren Sonden gleichzeitig bearbeitet. Verglichen mit lichtoptischen Lithographiesystemen ist der mit diesen Geräten erzielbare Durchsatz an strukturierten Wafern aber noch gering, da auf jede der Sonden nur ein Bruchteil des Quellenstroms entfällt. Es wird deshalb vorgeschlagen, den Strahlerzeuger (Q) des Lithographiegerätes mit mehreren vorzugsweise linienförmig angeordneten Elektronenquellen (Q1, Q2) auszustatten und diese mit Hilfe einer telezentrischen Elektronenoptik (L1, L2) verkleinert auf das zu strukturierende Objekt (W) abzubilden.

FIG 3

EP 0 359 018 A2

## Lithographiegerät zur Strukturierung eines Objektes.

Die Erfindung bezieht sich auf ein Lithographiegerät zur Strukturierung eines Objektes mit einer Vielzahl von Teilchensonden.

Aus der US-A-4 724 382 ist ein Lithographiegerät (Elektronenstrahlschreiber) bekannt, dessen elektronenoptische Säule eine Steuerblende zur Erzeugung einer Vielzahl individuell ablenk-bzw. austastbarer Elektronensonden aufweist. Diese in der EP-0 191 439 A1 näher beschriebene Blende besteht im wesentlichen aus einer Siliziumscheibe, deren mittlerer Teil als freitragende Membran ausgebildet und mit einer linienförmigen Anordnung quadratischer Ausnehmungen versehen ist. Als Ablenkeinheit dient ein im Bereich der Ausnehmungen angeordnetes Elektrodensystem.

Weitere Lithographiegeräte sind aus den US-A-4 130 761, 4 153 843, 4 409 487 und 4 524 278 bekannt.

In diesen Lithographiegeräten werden die Elektronensonden aus einer gemeinsamen Quelle gespeist, so daß auf jeden der Teilstrahlen nur ein Bruchteil des verfügbaren Quellenstroms entfällt. Zur Steigerung des Durchsatzes an strukturierten Halbleiterwafern sollte der Sondenstrom aber möglichst hoch sein.

Der Erfindung liegt die Aufgabe zugrunde, ein Lithographiegerät der eingangs genannten Art anzugeben, in dem der Sondenstrom deutlich höher ist als in konventionellen Systemen. Außerdem soll das Lithographiegerät eine hohe Auflösung besitzen. Diese Aufgaben werden erfindungsgemäß durch ein Lithographiegerät nach Patentanspruch 1 gelöst. Die Unteransprüche betreffen vorteilhafte Weiterbildungen der Erfindung.

Der mit der Erfindung erzielbare Vorteil besteht insbesondere darin, daß sich der Durchsatz an strukturierten Halbleiterkörpern deutlich erhöht.

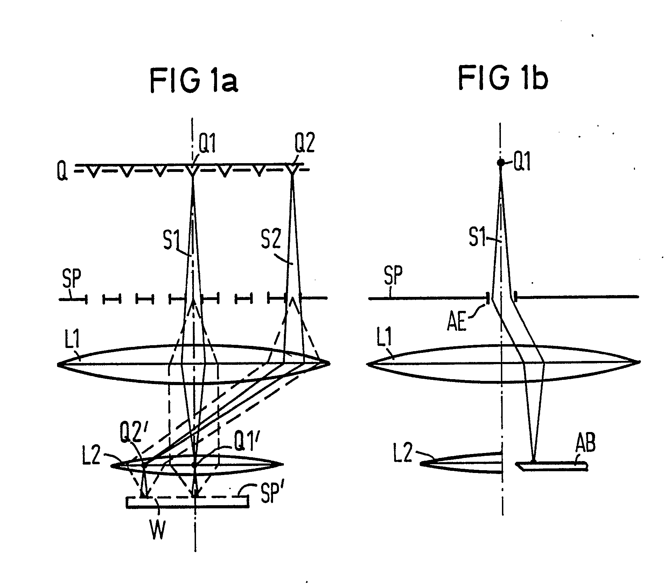

Die Erfindung wird im folgenden anhand der Zeichnungen näher erläutert. Hierbei zeigen die Figuren 1 bis 3 Ausführungsbeispiele erfindungsgemäßer Lithographiegeräte.

Das in Figur 1 schematisch dargestellte Lithographiegerät umfaßt einen aus mehreren Elektronenquellen Q1, Q2 bestehenden Strahlerzeuger Q, eine Steuerplatte SP zur Formung und Austastung der von den Quellen Q1, Q2 ausgehenden Elektronensonden S1, S2 und eine aus einer Kondensorlinse L1 und einer Objektivlinse L2 bestehende Elektronenoptik, die die von den Sonden S1, S2 ausgeleuchteten quadratischen oder rechteckförmigen Ausnehmungen der Steuerplatte SP verkleinert auf den mit einem Resist beschichteten Halbleiterkörper W abbildet. Die bei der Abbildung der vorzugsweise entlang einer Linie angeordneten Elektronenquellen Q1, Q2 auftretende Verzeichnung wird in dem erfindungsgemäßen Lithographiegerät durch einen telezentrischen Strahlengang erheblich reduziert. Hierbei ist es von Vorteil, wenn die Zwischenbilder $Q1'$, $Q2'$ der Quelle Q1, Q2 in der Objektivlinse L2 liegen. Der Strahlquerschnitt der Elektronensonden S1, S2 wird dann innerhalb der Objektivlinse L2 minimal, was besonders geringe Aberrationen und damit eine hohe Auflösung gewährleistet.

Als Steuerplatte SP kann insbesondere die aus der US-A-4 724 328 bzw. EP-0 191 439 A1 bekannte Blende verwendet werden. Diese besteht dann vorzugsweise aus einer Siliziumscheibe, die im mittleren Bereich als freitragende Membran ausgebildet und mit einer ebenfalls linienförmigen Anordnung quadratischer oder rechteckförmiger Ausnehmungen versehen ist. Wie die Figur 1b in der Seitenansicht zeigt, ist jeder der Ausnehmungen ein Ablenkelement AE, insbesondere ein Kondensatorplattenpaar, zugeordnet, an dessen Elektroden das Signal zur Ablenkung der jeweiligen Elektronensonde S1 anliegt. Die abgelenkte Sonde S1 trifft auf die vorzugsweise innerhalb der Objektivlinse L2 angeordnete Blende AB und wird dadurch ausgetastet. Auf diese Weise lassen sich beliebige hell-dunkel Muster mit Hilfe des linienförmigen Sonderarrays erzeugen.

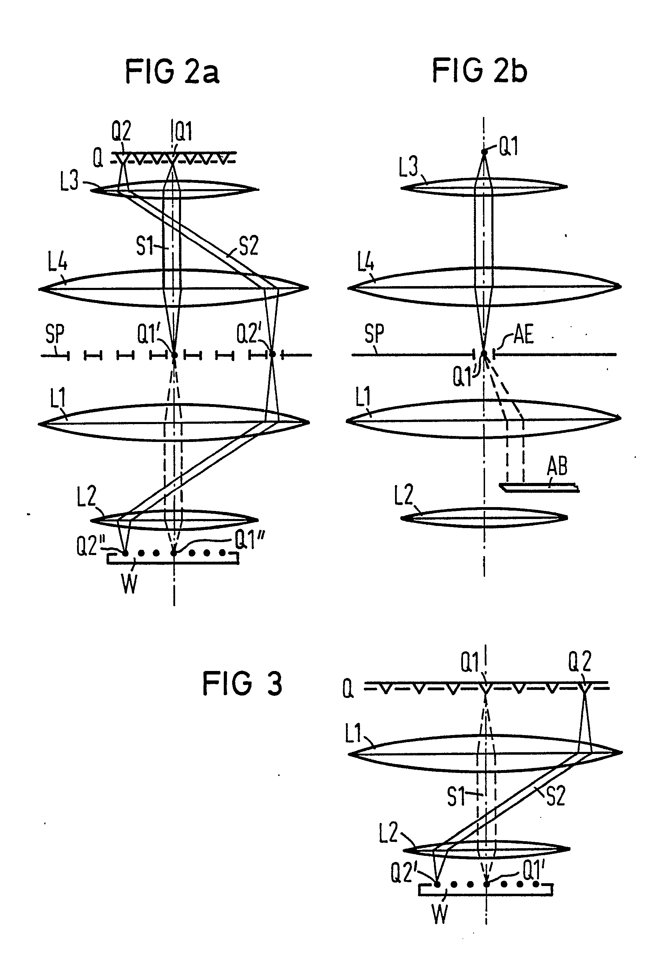

Das in Figur 2 schematisch dargestellte Lithographiegerät umfaßt ebenfalls einen Strahlerzeuger Q mit mehreren entlang einer Linie angeordneten Elektronenquellen Q1, Q2, eine Steuerplatte SP zur individuellen Austastung der von den Quellen Q1, Q2 ausgehenden Elektronensonden S1, S2 und eine aus einer Kondensorlinse L1 und einer Objektivlinse L2 bestehende telezentrische Elektronenoptik zur Fokussierung der Elektronensonden S1, S2 auf den zu strukturierenden Halbleiterkörper W. Zusätzlich ist noch eine aus den Linsen L3 und L4 bestehende Optik vorgesehen, die die linienförmige Elektronenquelle Q telezentrisch in die Ebene der Steuerplatte SP abbildet. Im Unterschied zu dem in Figur 1 dargestellten Lithographiegerät, bei dem die Elektronenquelle Q und die Steuerplatte SP als Objekt ebenso wie deren Bilder $Q1'$, $Q2'$ bzw. $SP'$ jeweils räumlich getrennt vorliegen (Köhler-Beleuchtung), ist in diesem Ausführungsbeispiel die sogenannte kritische Beleuchtung verwirklicht, wo Quelle $Q1'$, $Q2'$ und Objekt SP ebenso wie deren Bilder $Q1''$, $Q2''$ bzw. $SP'$ jeweils zusammenfallen. Jeder der Ausnehmungen der Steuerplatte SP ist wieder ein Kondensatorelement AE zugeordnet, um die Elektronensonden S1, S2 gegebenenfalls auf eine im Strahlengang unterhalb der Steuerplatte SP angeordnete Austastblende AB abzulenken (siehe Figur 2b).

In den erfindungsgemäßen Lithographiegeräten wird jede Elektronensonde S1, S2 aus einer eigenen Quelle Q1 bzw. Q2 gespeist. Als Elektronenquellen Q1, Q2 kommen insbesondere die aus J. Vac. Sci. Technol. A5 (4), Juli/August 1987, Seite 1544 bis 1548 bekannten Silizium-Kaltkathoden, lasergepumpte Photokathoden (Applied Physics Letters 51.2, Juli 1987, Seite 145 bis 147), LaB6-Einkristall-Schneidenemitter (US-A-4 724 328) und die in SRI International Technical Note 2, November 1984 beschriebenen Feldemissionskathoden in Betracht. Besondere Vorteile bieten Silizium-Kaltkathoden und Feldmissionskathoden nach Spindt, deren Emissionsstrom sich sehr schnell schalten läßt.

Ein mit solchen Quellen ausgestattetes Lithographiegerät benötigt keine Steuerplatte SP mit der zugehörigen Beleuchtungsoptik L3, L4, da die Austastung der Elektronensonden S1, S2 dann im Strahlerzeuger Q selbst vorgenommen wird. Wie die Figur 3 schematisch zeigt, vereinfacht sich der Aufbau des Lithographiegerätes dadurch erheblich.

## Ansprüche

1. Lithographiegerät zur Strukturierung eines Objektes (W) mit einer Vielzahl von Teilchensonden (S1, S2), **gekennzeichnet durch** einen aus mehreren linienförmig angeordneten Teilchenquellen (Q1, Q2) bestehenden Strahlerzeuger (Q) und eine erste telezentrische Einheit (L1, L2) zur Fokussierung der Teilchensonden (S1, S2) auf das Objekt (W).

2. Lithographiegerät nach Anspruch 1, **gekennzeichnet durch** eine Einrichtung (SP) zur individuellen Austastung der Teilchensonden (S1, S2).

3. Lithographiegerät nach Anspruch 2, **dadurch gekennzeichnet,** daß die Einrichtung (SP) aus einer Blende besteht, die eine zeilenförmige Anordnung von Ausnehmungen zum Durchtritt der Teilchensonden (S1, S2) und Ablenkelemente (AE) zur individuellen Ablenkung der Teilchensonden (S1, S2) auf eine Strahlaustastblende (AB) aufweist.

4. Lithographiegerät nach Anspruch 3, **dadurch gekennzeichnet,** daß die Blende (SB) derart im Strahlengang oberhalb der ersten telezentrischen Einheit (L1, L2) angeordnet ist, daß deren Ausnehmungen telezentrisch auf das Objekt (W) abgebildet werden.

5. Lithographiegerät nach Anspruch 4, **dadurch gekennzeichnet,** daß die erste telezentrische Einheit (L1, L2) eine Objektivlinse (L2) aufweist und daß ein Zwischenbild (Q1', Q2') der Teilchenquellen (Q1, Q2) in der Objektivlinse (L2) liegt.

6. Lithographiegerät nach einem der Ansprüche 1 bis 5, **gekennzeichnet durch** eine zweite telezentrische Einheit (L3, L4) zur Abbildung der Teilchenquellen (Q1, Q2) in die Ebene der Blende (SP).

7. Lithographiegerät nach einem der Ansprüche 3 bis 6, **dadurch gekennzeichnet,** daß die Strahlaustastblende (AB) innerhalb der Objektivlinse (L2) angeordnet ist.

# FIG 1a

# FIG 1b

FIG 2a    FIG 2b

FIG 3